# EUROPEAN PATENT APPLICATION

(11) **EP 2 031 515 A1**
(43) Date of publication of application: **04.03.2009**
(21) Application number: 07743616.0
(22) Date of filing: 11.05.2007
(51) Int. Cl.: G06F 12/00

(54) **DATA MEMORY DEVICE AND METHOD FOR INITIALIZING SAME**

(30) Priority: 16.05.2006 JP 2006136237
(71) Applicant: Buffalo Inc., Nagoya-shi, Aichi 457-8520 (JP)
(72) Inventor: ARAKAWA, Tadashi, Nagoya-shi, Aichi 457-8520 (JP)
(74) Representative: Tomlinson, Kerry John
(86) International application number: PCT/JP2007/060181
(87) International publication number: WO 2007/132931

(57) **Abstract**

A data storage apparatus comprises a USB connector, a USB control circuit, a flash controller, and a flash memory. After the process of formatting the data storage apparatus by a host device, the flash controller forcibly rewrites FAT number data recorded in a bios parameter block area from '2' to '1' at the time of restoration of power supply. Such rewriting of the FAT number data causes the host device to identify the presence of only one FAT area. This arrangement desirably improves the data writing efficiency of the data storage apparatus configured to generate multiple management tables in the formatting process by the host device.

## Description

### TECHNICAL FIELD

The present invention relates to an initialization technique of a data storage apparatus that stores data transferred from a host device.

### BACKGROUND ART

There are various storages, for example, a hard disk drive, a memory card, and a USB flash drive as the data storage apparatus that stores data transferred from a host device, such as a computer. A file system called FAT is generally applied to such data storage apparatuses. An initialization process (formatting process) according to an FAT file system stores a management table called a file allocation table in the data storage apparatus. The file allocation table records management information provided for each file as a management object to represent a cluster structure and a storage location of the file.

Such information recorded in the file allocation table is of great importance. The host device accordingly provides two file allocation tables of identical contents in the data storage apparatus in the initialization process of the data storage apparatus. Even when one of the file allocation tables is somehow damaged, normal data reading and data writing operations are ensured by the use of the other file allocation table (see JP-AH11-249968).

The latest data storage apparatus is generally designed to enable error correction based on ECC data by the device alone and accordingly has high reliability for data storage. Although the formatting process by the host device provides two file allocation tables of identical contents, it is extremely rare to use the second file allocation table. In this circumstance, individually recording the identical file management information in the two file allocation tables undesirably lowers the data writing efficiency. This problem is not unique to the FAT file system but is commonly found in data storage apparatuses adopting any file systems requiring record of two or more management tables of identical contents, as well as the data storage apparatus adopting the FAT file system.

### DISCLOSURE OF THE INVENTION

By taking into account this problem of the prior art, there would be a demand for improving the data writing efficiency in a data storage apparatus configured to generate multiple management tables in a formatting process by a host device.

In order to accomplish at least part of the demand mentioned above and other relevant demands, one aspect of the invention is directed to a data storage apparatus that stores data transferred from a host device. The data storage apparatus comprises: a storage device subjected to a formatting process by the host device to provide a data memory area for storing the data and configured to store multiple management tables of identical content used for management of a storage location of each piece of data stored in the data memory area and table number data representing a number of the multiple management tables; a rewriting module that rewrites the table number data stored in the storage device from a value recorded by the formatting process to a smaller value, after the formatting process by the host device; and an output module that outputs the rewritten table number data to the host device, in response to a request from the host device, prior to the transfer of the data from the host device.

While the formatting process by the host device stores multiple management tables of identical content, the data storage apparatus according to this aspect of the invention rewrites the table number data to forcibly reduce the number of the valid management tables. This arrangement desirably reduces the frequency of recording the data storage location into the management table by the host device to a less number of times, thus improving the writing efficiency of the data storage apparatus and enhancing the processing speed. Latest storage devices, such as a flash memory and a hard disk, are generally designed to enable error correction based on ECC data, independently of the host device. There is accordingly little possibility of lowering the reliability of data storage by the reduction of the number of the valid management tables.

In one preferable application of the data storage apparatus according to the above aspect of the invention, the host device performs the formatting process according to an FAT file system. The storage device stores multiple file allocation tables according to the FAT file system as the multiple management tables. The storage device stores a number of the multiple file allocation tables as the table number data in a bios parameter block area provided in the storage device according to the FAT file system.

This arrangement enhances the processing speed of the data storage apparatus formatted according to the versatile FAT file system and improves the user's convenience.

In the data storage apparatus having any of the above arrangements, the storage device may be a non-volatile semiconductor memory.

The use of the non-volatile semiconductor memory actualizes a highly portable small-sized data storage apparatus. Typical examples of the non-volatile semiconductor memory include a NAND flash memory, a NOR flash memory, an EEPROM, and a battery backed-up DRAM. The storage device is not restricted to the semiconductor memory but may be a hard disk drive or a rewritable optical disk.

The data storage apparatus of the invention may be connected with the host device via a USB interface.

The data storage apparatus of the present invention is readily usable by simply connecting the data storage apparatus to the USB interface provided in the host device. This arrangement desirably improves the user's convenience. The USB interface used for the connection of the data storage apparatus with the host device is not restrictive but may be replaced by another interface, for example, a PCMCIA interface, a serial ATA interface, or an IEEE1394 interface.

The technique of the invention is not restricted to the data storage apparatus having any of the above arrangements but is also actualized by an initialization method of such a data storage apparatus.

### BRIEF DESCRIPTION OF THE DRAWINGS

Fig. 1 schematically illustrates the configuration of a data storage apparatus and a host device;
Fig. 2 shows the data structure in the data storage apparatus;
Fig. 3 is a flowchart showing a main process routine;
Fig. 4 is a flowchart showing a FAT number rewriting process;
Fig. 5 is a flowchart showing a write process; and
Fig. 6 is a flowchart showing a read process.

### BEST MODES OF CARRYING OUT THE INVENTION

In order to elucidate the functions, the advantages, and the effects of the invention, one mode of carrying out the invention is described below in the following sequence as a preferred embodiment:
A. General Configuration of Data storage apparatus
B. Main Process
C. FAT Number Rewriting Process
D. Write Process
E. Read Process
F. Effects
G. Modifications

### A. General Configuration of Data storage apparatus

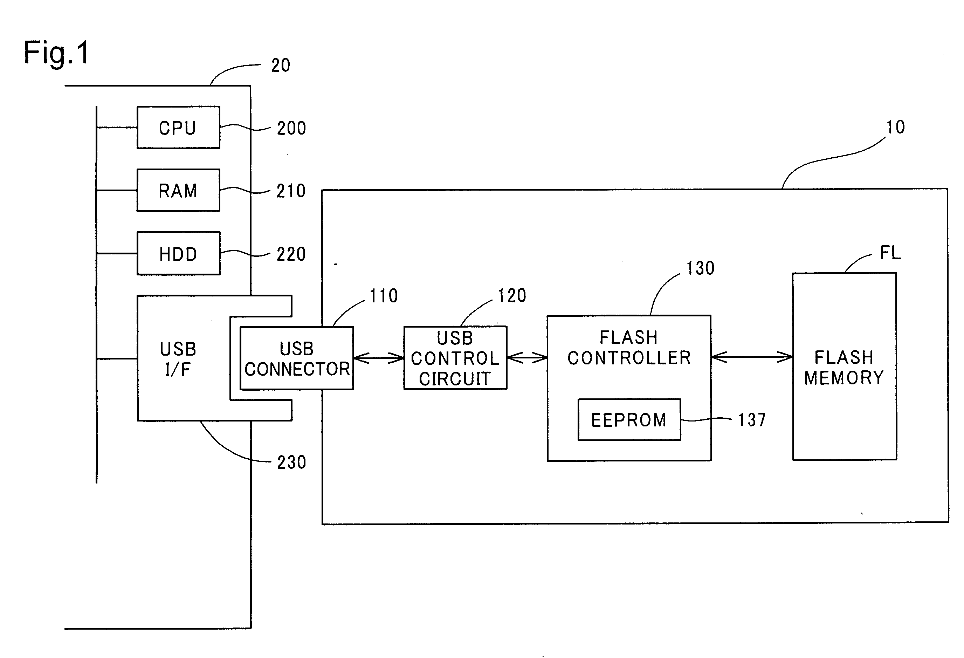

Fig. 1 schematically illustrates the configuration of a data storage apparatus 10 and a host device 20 in one embodiment of the invention. The host device 20 is constructed by a general personal computer and includes a CPU 200, a RAM 210, a hard disk drive 220 with an operating system and a communication control driver for controlling communication with the data storage apparatus 10 installed therein, and a USB interface 230, as illustrated. The data storage apparatus 10 includes a USB connector 110, a USB control circuit 120, a flash controller 130, and a flash memory FL.

The USB connector 110 is exposed on a casing of the data storage apparatus 10 and is connected to the USB interface 230 of the host device 20. In the configuration of this embodiment, electric power required for driving the data storage apparatus 10 is supplied from the host device 20 via the USB connector 110. The electric power may otherwise be supplied from an AC adapter (not shown) connected to the data storage apparatus 10.

The USB control circuit 120 is connected with the USB connector 110 and with the flash controller 130. The USB control circuit 120 causes the data storage apparatus 10 to work as a USB mass storage class device and controls communication of the data storage apparatus 10 with the host device 20 according to a USB protocol. The USB control circuit 120 also has the functions of converting a USB command received from the host device 20 into an ATA command or an SCSI command and converting data or a status signal received from the flash controller 130 into a USB command. The ATA command and the SCSI command are standardized commands by ANSI (American National Standard Institute) and have the general versatility to control data reading and data writing from and to not only the data storage apparatus 10 of the embodiment but diversity of other data storage apparatuses including a hard disk and a PC card memory.

The flash controller 130 is an integrated circuit constructed to interpret the ATA command transferred from the USB control circuit 120 and to control data reading and data writing from and to the flash memory FL. The flash controller 130 internally has a CPU, a ROM, and a RAM for such control. A program for controlling the operations of the data storage apparatus 10 is recorded in the ROM. The CPU uses the RAM as a work area and executes the recorded program to control the general operations of the data storage apparatus 10.

The flash controller 130 has an EEPROM 137. An FAT control flag is stored in the EEPROM 137 to control the number of FAT areas provided in the flash memory FL. The functions of the FAT control flag will be described later in detail.

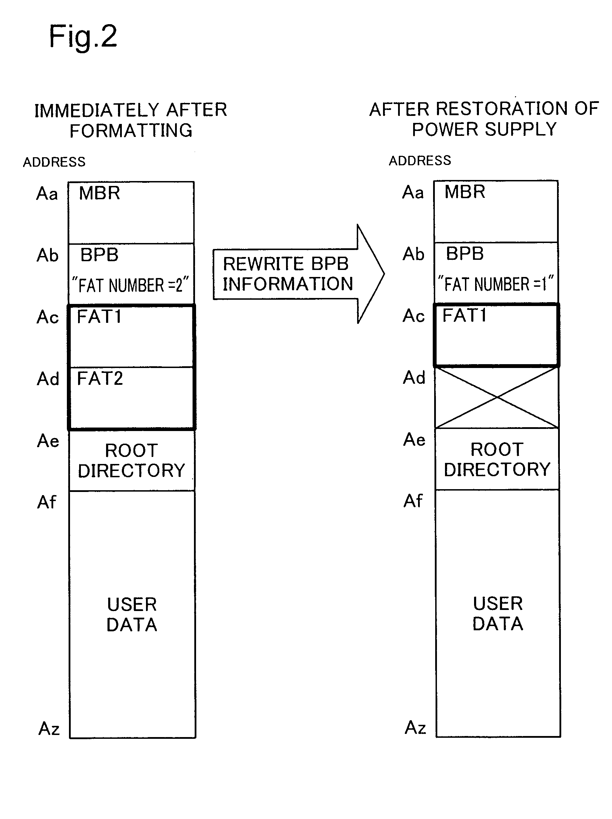

Fig. 2 shows the data structure in the data storage apparatus 10. A formatting process performed by the host device 20 according to an FAT file system generates various areas in the data storage apparatus 10 as shown by the left drawing. In a sequence from a head address of the flash memory FL, the generated areas include a master boot record area (hereafter referred to as 'MBR area'), a bios parameter block area (hereafter referred to as 'BPB area'), an FAT1 area, an FAT2 area, a root directory area, and a user data area.

The MBR area is read first on connection of the data storage apparatus 10 with the host device 20. Pieces of information including a bootstrap code and a partition table (hereafter these pieces of information are referred to as 'MBR information') are recorded in the MBR area. The partition table stores relevant pieces of information, for example, the number of generated partitions, a starting sector and an end sector of each partition, offsets, and the total number of sectors. The description of this embodiment is on the assumption that only one partition is generated.

The BPB area is provided in a head sector of each partition and stores a format type of the partition, the number of sectors in the partition, and FAT number data representing the number of file allocation tables as explained later (hereafter these pieces of information are collectively referred to as 'BPB information'). The FAT file system generally provides two file allocation tables. After the formatting process by the host device 20, the FAT number data is accordingly set equal to '2'. In response to connection of the data storage apparatus 10 to the user interface 230 of the host device 20, the host device 20 refers to the FAT number data recorded in the BPB area to identify the number of file allocation tables provided in the data storage apparatus 10. The host device 20 writes the management information into the file allocation tables according to the identified number of the file allocation tables.

Each of the FAT1 area and the FAT2 area stores a file allocation table showing the location and the cluster structure of each file recorded in the user data area. The general formatting process according to the FAT file system provides two file allocation tables of identical contents to be respectively recorded in the FAT1 area and in the FAT2 area.

The root directory area stores the file name, the extension, and the attribute of each file recorded in the user data area, as well as a cluster number of a first cluster as a constituent of the file.

The user data area stores the substance of each file transferred from the host device 20.

The data storage apparatus 10 has the function of rewriting the FAT number data set equal to '2' in the BPB area to a value '1' at the time of restoration of power supply after the formatting process by the host device 20, as shown in the right half drawing of Fig. 2. In response to restoration of power supply to the data storage apparatus 10 caused by, for example, detachment and reattachment of the data storage apparatus 10 from and to the USB interface 230, the host device 20 gives a reading request to the data storage apparatus 10 to read the MBR information and the BPB information including the FAT number data from the data storage apparatus 10, prior to an actual file access, such as a file transfer. The host device 20 refers to the read pieces of information and determines a subsequent access mode. When the FAT number data is rewritten from '2' to '1' on restoration of power supply to the data storage apparatus 10, the host device 20 reads the rewritten FAT number data and makes a subsequent file access on the assumption of the presence of only one valid file allocation table. Even when there are actually two FAT areas, the FAT number data rewritten to '1' allows an access to only one of the FAT areas.

For the convenience of explanation, the FAT2 area is deleted in the right half drawing of Fig. 2. The actual procedure, however, only rewrites the FAT number data and leaves the FAT2 area without deletion. The FAT number data rewritten to '1' causes the host device 20 to make access to only the FAT1 area and not to make access to the FAT2 area left without deletion as explained above. The FAT2 area is left without deletion in the embodiment but may alternatively be deleted simultaneously with rewriting of the FAT number data. In the latter case, it is preferable to link the root directory area and the subsequent user data area with the FAT1 area. This enables the capacity corresponding to the FAT2 area to be effectively used for, for example, the user data area.

### B. Main Process

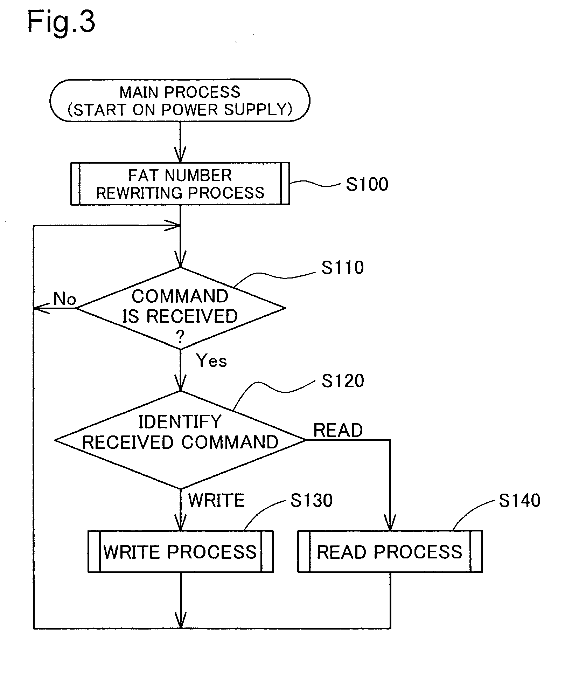

Fig. 3 is a flowchart showing a main process routine executed by the data storage apparatus 10. The flash controller 130 starts this main process flow simultaneously with connection of the data storage apparatus 10 to the host device 20 and start of power supply to the data storage apparatus 10.

On the start of the main process, the flash controller 130 first performs an FAT number rewriting process to rewrite the FAT number data from '2' to '1' according to the requirement (step S100). The details of the FAT number rewriting process will be described later.

The flash controller 130 subsequently determines whether any command is received from the host device 20 via the USB control circuit 120 (step S110). When no command is received (step S110: no), the flash controller 130 repeats this decision step to wait for reception of any command. When any command is received (step S110: yes), on the other hand, the flash controller 130 identifies the received command (step S120).

When the received command is identified as a write command for writing data (step S120: 'write'), the flash controller 130 performs a write process described later (step S130). When the received command is identified as a read command for reading data (step S120: 'read'), on the other hand, the flash controller 130 performs a read process described later (step S140). On completion of either the write process or the read process, the main process flow goes back to step S110. The main process repeats the series of processing in response to a command received from the host device 20 until cutoff of the power supply.

### C. FAT Number Rewriting Process

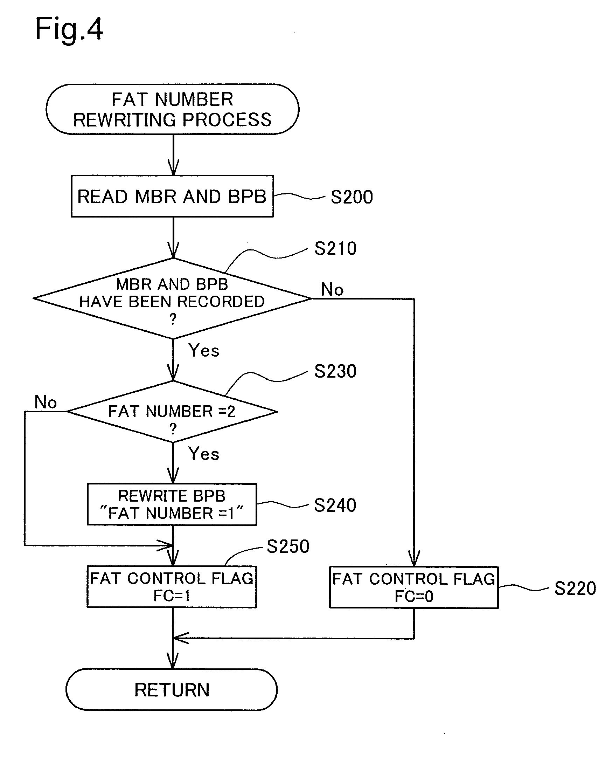

Fig. 4 is a flowchart showing the FAT number rewriting process executed at step S100 in the main process routine. This FAT number rewriting process rewrites the FAT number data from '2' to '1'. This process is triggered by restoration of power supply to the host device 20 kept in connection with the data storage apparatus 10 subsequent to cutoff of the power supply to the host device 20 or by restoration of power supply to the data storage apparatus 10 through detachment and reattachment of the data storage apparatus 10 from and to the USB interface 230 of the host device 20.

On the start of the FAT number rewriting process triggered by restoration of power supply to the data storage apparatus 10, the flash controller 130 first reads the MBR area and the BPB area generated in the flash memory FL (step S200) and determines whether the MBR information and the BPB information have already been written in the MBR area and the BPB areas (step S210).

Upon determination that the MBR information and the BPB information have not yet been written (step S210: no), it means that the data storage apparatus 10 has not yet been formatted according to the FAT file system. The flash controller 130 accordingly sets an FAT control flag FC to '0' and records the setting of the FAT control flag FC into the EEPROM 137 (step S220). The FAT control flag FC set equal to '1' shows that the FAT number data has been rewritten from '2' to '1', while the FAT control flag FC set equal to '0' represents no such rewriting.

Upon determination that the MBR information and the BPB information have already been written (step S210: yes), on the other hand, it means that the data storage apparatus has already been formatted by the host device 20 according to the FAT file system. The flash controller 130 then refers to the FAT number data recorded as a piece of the BPB information and identifies whether the FAT number data is equal to '2' (step S230). Upon identification of the FAT number data equal to '2' (step S230: yes), the flash controller 130 rewrites the FAT number data recorded in the BPB area from '2' to '1' (step S240). Upon identification of the FAT number data equal to '1' (step S230: no), on the other hand, the flash controller 130 does not perform such rewriting.

Upon identification of the FAT number data equal to '1' (step S230: no) or after rewriting of the FAT number data to '1' at step S240, the flash controller 130 sets the FAT control flag to '1' and records the setting of the FAT control flag into the EEPROM 137 (step S250).

As explained above, at the time of first power supply after formatting of the data storage apparatus 10 by the host device 20, the FAT number rewriting process rewrites the FAT number data from '2' to '1' at step S240. Even when there are actually two file allocation tables, such rewriting of the FAT number data enables the host device 20 to identify the presence of only one valid file allocation table.

The FAT number rewriting process of this embodiment refers to the setting of the FAT number data recorded in the BPB area and identifies the requirement for rewriting the FAT number data from '2' to '1' at step S230. One modified flow of the FAT number rewriting process may write the FAT number data fixed to '1' into the EEPROM 137 without such identification, in response to an affirmative answer 'YES' at step S210. The procedure of the embodiment rewrites the FAT number data from '2' to '1' in response to identification of the FAT number data equal to '2', while not performing such rewriting but keeping the FAT number data to '1' in response to identification of the FAT number data equal to '1'. In either case, the FAT number data is eventually set equal to '1'. Writing the FAT number data fixed to '1' omits the conditional branching and thus desirably simplifies the whole processing flow.

### D. Write Process

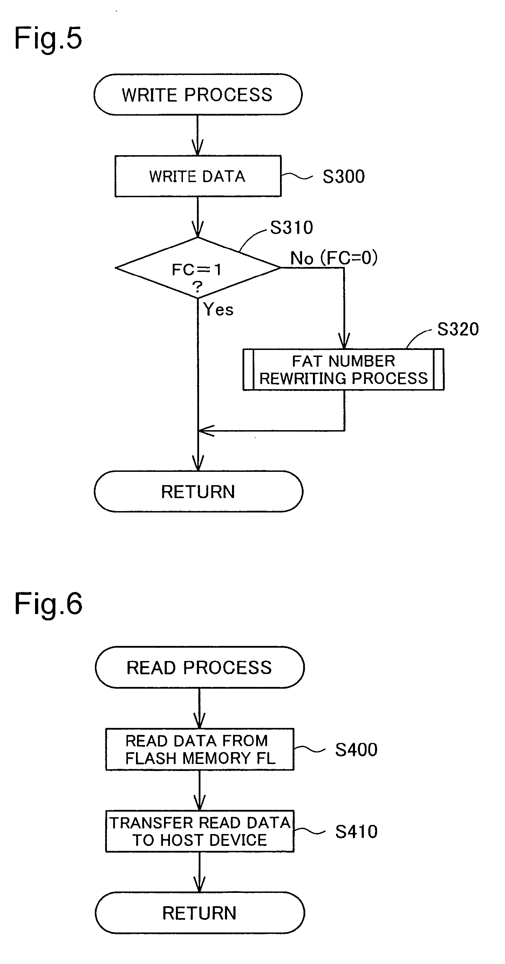

Fig. 5 is a flowchart showing the write process executed at step S130 in the main process routine explained above. The write process is performed to write data received from the host device 20 into the flash memory FL.

In the write process, the flash controller 130 first writes data received from the host device 20 via the USB control circuit 120 at a specified address in the flash memory FL (step S300).

The flash controller 130 then refers to the EEPROM 137 and identifies whether the FAT control flag FC is equal to '1' (step S310). The FAT control flag FC identified as '0' (step S310: no) means that the FAT number data has not yet been rewritten from 2' to '1' or that the data storage apparatus 10 has not yet been formatted according to the FAT file system. Rewriting the FAT number data may thus be required in the process of writing data at step S300. The flash controller 130 accordingly performs an FAT number rewriting process, which is identical with the FAT number rewriting process of Fig. 4 (step S320), and terminates the write process.

The FAT control flag FC identified as '1' (step S310: yes), means that the FAT number data has already been rewritten to '1' to attain the high-speed data writing. In this case, the write process is terminated without execution of the FAT number rewriting process.

As explained above, writing the MBR information and the BPB information into the MBR area and the BPB area provided in the flash memory FL at step S300 causes the data storage apparatus 10 to be formatted according to the FAT file system by the host device 20. In this case, the FAT number rewriting process shown in Fig. 4 is performed to rewrite the FAT number data from '2' to '1' immediately after the formatting process. The write process thus enables the FAT number data to be written from '2' to '1' immediately after the formatting process by the host device 20 without waiting for restoration of power supply to the data storage apparatus 10.

### E. Read Process

Fig. 6 is a flowchart showing the read process executed at step S140 in the main process routine explained above. The read process is performed to read data from the flash memory FL in response to a reading request given by the host device 20.

In the read process, the flash controller 130 first analyzes a read command received from the host device 20 via the USB control circuit 120 and reads data from a specified address in the flash memory FL (step S400). The read data is then transferred to the host device 20 (step S410). After the data transfer, the read process of the embodiment is terminated.

At the time of power supply to the data storage apparatus 10, with a view to ensuring an adequate file access to the memory area in the data storage apparatus 10, the host device 20 gives a reading request to read the MBR information and the BPB information including the FAT number data, prior to an actual reading or writing operation of user data. In response to reception of the reading request, the data storage apparatus 10 outputs the required pieces of information including the FAT number data to the host device 20 according to the read process. The host device 20 receives the information including the FAT number data from the data storage apparatus 10 to adequately identify the number of file allocation tables provided in the data storage apparatus 10 and the data capacity. When the FAT number data output from the data storage apparatus 10 is equal to '1', the host device 20 identifies '1' as the number of file allocation tables provided in the data storage apparatus 10 and performs a subsequent data reading or writing operation on the assumption of the presence of only one file allocation table. This arrangement enables a high-speed file access.

### F. Effects

As described above, even when the formatting process of the host device 20 provides two file allocation tables (two FAT areas), the data storage apparatus 10 of the embodiment rewrites the FAT number data from '2' to '1' to substantially reduce the number of the valid file allocation tables to '1'. Such rewriting desirably reduces the frequency of writing the management information by the host device 20 into the file allocation table from the ordinary two times to one time and thus significantly enhances the data writing efficiency. Namely this arrangement effectively enhances the processing speed of the data storage apparatus 10.

### G. Modifications

The embodiment discussed above is to be considered in all aspects as illustrative and not restrictive. There may be many modifications, changes, and alterations without departing from the scope or spirit of the main characteristics of the present invention. Some examples of possible modification are given below.

### (G1) Modification 1

The data storage apparatus 10 of the embodiment has a flash memory as the storage device. The flash memory is, however, neither essential nor restrictive but may be replaced by any other suitable storage device, for example, a hard disk drive or a rewritable optical disk.

### (G2) Modification 2

The data storage apparatus 10 of the embodiment is formatted according to the FAT file system. The FAT file system is, however, neither essential nor restrictive, but any other file system of providing multiple management tables of identical contents may be adopted for formatting the data storage apparatus 10.

### (G3) Modification 3

In the configuration of the embodiment, the host device 20 and the data storage apparatus 10 are interconnected by the USB interface. The USB interface is, however, neither essential nor restrictive but may be replaced by any other suitable interface adopted for connection, for example, a PCMCIA interface, a serial ATA interface, or an IEEE 1394 interface.

### (G4) Modification 4

The data storage apparatus 10 of the embodiment unconditionally rewrites the FAT number data from '2' to '1' when being formatted by the host device 20. In one modification, the data storage apparatus 10 may have a mechanical switch to allow or prohibit such rewriting. The data storage apparatus 10 of this modified structure detects the condition of the switch at the time of power supply to the data storage apparatus 10 and rewrites the FAT number data from '2' to '1' or keeps the setting of the FAT number data to '2' according to the detected switch condition. This modified arrangement enables the user to readily select an ordinary mode of using two file allocation tables and a mode of enabling a high-speed file access with substantial reduction to only one valid file allocation table.

In this modified structure, however, once the FAT number data is reduced to '1', any of the processes explained in the above embodiment cannot return the FAT number data to '2'. When the condition of the switch is changed over to return the reduced FAT number data from '1' to '2', the data storage apparatus 10 is required to reset the FAT number data to '2' and copy the data recorded in the FAT1 area to the FAT2 area at the time of power supply. This enables two valid file allocation tables to be provided adequately even once rewriting the FAT number data to 1.

### (G5) Modification 5

In the embodiment described above, the FAT number rewriting process is performed in both the main process flow and the write process flow. One modification may omit the FAT number rewriting process from the main process flow and perform the FAT number rewriting process only in the write process flow. Another modification may omit the FAT number rewriting process from the write process flow and perform the FAT number rewriting process only in the main process flow. The former modification enables the FAT number data to be rewritten immediately after the formatting process. The latter modification causes the FAT number data to be rewritten after restoration of the power supply, thus allowing stable operations of the host device 20. The performance of the FAT number rewriting process in both the main process flow and the write process flow as explained in the embodiment enables the FAT number data to be definitely rewritten from '2' to '1'.

### (G6) Modification 6

In the description of the embodiment, the data storage location in the flash memory is expressed by the terminology 'address'. This term 'address' is, however, not restrictive but is replaceable with any of equivalent terms, for example, 'sector', 'cluster', or 'block' according to the file system, the operating system, or the storage device adopted.

None of the embodiment, its modifications, and its applications described above is to be interpreted in a restrictive manner. The scope and spirit of the present invention are indicated by the appended claims, rather than by the foregoing description.

## Claims

1. A data storage apparatus that stores data transferred from a host device, the data storage apparatus comprising:
a storage device subjected to a formatting process by the host device to provide a data memory area for storing the data and configured to store multiple management tables of identical content used for management of a storage location of each piece of data stored in the data memory area and table number data representing a number of the multiple management tables;
a rewriting module that rewrites the table number data stored in the storage device from a value recorded by the formatting process to a smaller value, after the formatting process by the host device; and
an output that outputs the rewritten table number data to the host device, in response to a request from the host device, prior to the transfer of the data from the host device.

2. The data storage apparatus in accordance with claim 1, wherein the host device performs the formatting process according to an FAT file system.

3. The data storage apparatus in accordance with claim 2, wherein the storage device stores multiple file allocation tables according to the FAT file system as the multiple management tables.

4. The data storage apparatus in accordance with claim 3, wherein the storage device stores a number of the multiple file allocation tables as the table number data in a bios parameter block area provided in the storage device according to the FAT file system.

5. The data storage apparatus in accordance with any one of claims 1 through 4, wherein the storage device is a non-volatile semiconductor memory.

6. The data storage apparatus in accordance with claim 5, wherein the non-volatile semiconductor memory is a flash memory.

7. The data storage apparatus in accordance with any one of claims 1 through 6, the data storage apparatus being connected with the host device via a USB interface.

8. An initialization method of a data storage apparatus, the data storage apparatus having a storage device that stores data transferred from a host device,
the initialization method comprising:
making the data storage apparatus subjected to a formatting process by the host device to provide a data memory area for storing the data in the storage device, and storing multiple management tables of identical content used for management of a storage location of each piece of data stored in the data memory area and table number data representing a number of the multiple management tables;
after the formatting process by the host device, rewriting the table number data stored in the storage device from a value recorded by the formatting process to a smaller value; and
outputting the rewritten table number data to the host device, in response to a request from the host device, prior to the transfer of the data from the host device.
